# EUROPEAN PATENT APPLICATION

(11) **EP 4 432 341 A1**
(43) Date of publication of application: **18.09.2024**
(21) Application number: 23215642.2
(22) Date of filing: 11.12.2023
(51) Int. Cl.: H01L 21/8234, H01L 27/06, H01L 29/417, H01L 29/775, H01L 29/423, H01L 23/528, H01L 29/06, H01L 21/336, B82Y 10/00

(54) **SEMICONDUCTOR DEVICES**

(30) Priority: 17.03.2023 KR 20230035077
(71) Applicant: Samsung Electronics Co., Ltd., Suwon-si, Gyeonggi-do 16677 (KR)
(72) Inventor: KIM, Sungmin, 16677 Suwon-si (KR)
(74) Representative: Marks & Clerk LLP

(57) **Abstract**

A semiconductor device includes first channel patterns adjacent to each other, a first gate electrode that overlaps with one of the first channel patterns, first source/drain patterns between the first channel patterns, and a first active contact in contact with a side surface of each of the first source/drain patterns. A crystal plane of the side surface of each of the first source/drain patterns is one of { 100} planes.

## Description

### BACKGROUND

The present disclosure relates to semiconductor devices, and more particularly, to semiconductor devices including a source/drain pattern.

A semiconductor device may include an integrated circuit including metal-oxide-semiconductor field effect transistors (MOSFETs). As sizes and design rules of semiconductor devices have been reduced, MOSFETs have been scaled down. Operating characteristics of semiconductor devices may be deteriorated by reduction in the size of MOSFETs. Accordingly, various research is being conducted for semiconductor devices capable of overcoming limitations according to a high integration density of semiconductor devices and of improving performance of semiconductor devices.

### SUMMARY

Embodiments of the inventive concepts may provide semiconductor devices with improved electrical characteristics and reliability.

According to some aspects of the inventive concepts, a semiconductor device may include first channel patterns adjacent to each other, a first gate electrode that overlaps with one of the first channel patterns, first source/drain patterns between the first channel patterns, and a first active contact in contact with a side surface of each of the first source/drain patterns. A crystal plane of the side surface of each of the first source/drain patterns may be one of {100} planes.

According to some aspects of the inventive concepts, a semiconductor device may include first channel patterns adjacent to each other, a first gate electrode that overlaps with one of the first channel patterns, first source/drain patterns between the first channel patterns, and a first active contact in contact with a side surface of each of the first source/drain patterns. The side surface of each of the first source/drain patterns may be substantially planar. The first active contact may include a first portion in contact with respective bottom surfaces of the first source/drain patterns, and a second portion in contact with the side surface of each of the first source/drain patterns. A width of the second portion of the first active contact may decrease as a distance to a top surface of the first portion of the first active contact decreases.

According to some aspects of the inventive concepts, a semiconductor device may include first channel patterns adjacent to each other, a first gate electrode that overlaps with one of the first channel patterns, first source/drain patterns between the first channel patterns, and a first active contact in contact with the first source/drain patterns. The first active contact may include a first portion and a second portion. The second portion of the first active contact may be between the first source/drain patterns and on the first portion of the first active contact. Each of the first channel patterns may include semiconductor patterns that overlap with each other. A crystal plane of a side surface of each of the semiconductor patterns may be one of { 100} planes. The first source/drain patterns may each include a side surface in contact with the second portion of the first active contact. A crystal plane of the side surface of each of the first source/drain patterns may be the one of the { 100} planes.

At least some of the above and other features of the invention are set out in the claims.

### BRIEF DESCRIPTION OF THE DRAWINGS

FIG. 1A is a plan view illustrating a semiconductor device according to some embodiments of the inventive concepts.
FIG. 1B is a cross-sectional view taken along a line A1-A1' of FIG. 1A.
FIG. 1C is a cross-sectional view taken along a line A2-A2' of FIG. 1A.
FIG. 1D is a cross-sectional view taken along a line A3-A3' of FIG. 1A.
FIG. 1E is a cross-sectional view taken along a line A4-A4' of FIG. 1A.
FIG. 1F is an enlarged view illustrating a region 'E1' of FIG. 1B.
FIGS. 2A, 2B, 2C, 2D, 2E and 2F are cross-sectional views illustrating a method of manufacturing the semiconductor device according to FIGS. 1A to 1F.
FIG. 3A is a plan view illustrating a semiconductor device according to some embodiments of the inventive concepts.
FIG. 3B is a cross-sectional view taken along a line B1-B1' of FIG. 3A.
FIG. 3C is a cross-sectional view taken along a line B2-B2' of FIG. 3A.
FIG. 3D is a cross-sectional view taken along a line B3-B3' of FIG. 3A.
FIG. 3E is an enlarged view illustrating a region 'E2' of FIG. 3B.
FIGS. 4A, 4B, 4C, 4D and 4E are cross-sectional views illustrating a method of manufacturing the semiconductor device according to FIGS. 3A to 3E.
FIG. 5 is a cross-sectional view illustrating a semiconductor device according to some embodiments of the inventive concepts.

### DETAILED DESCRIPTION

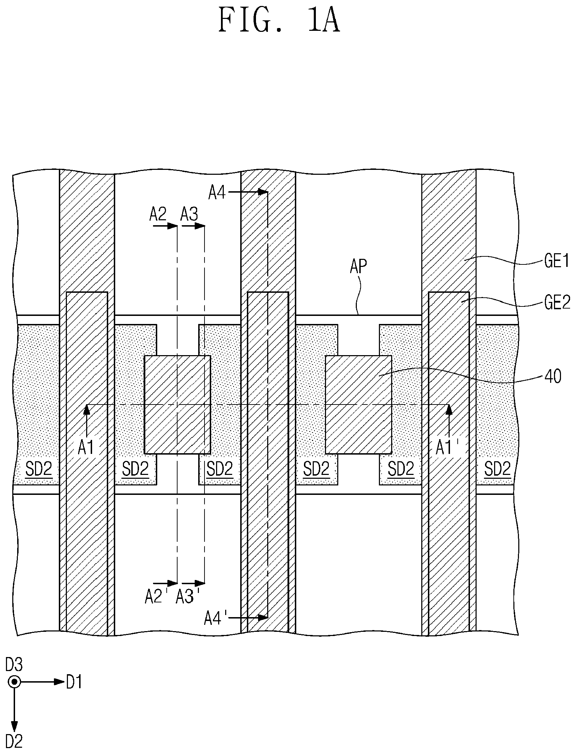

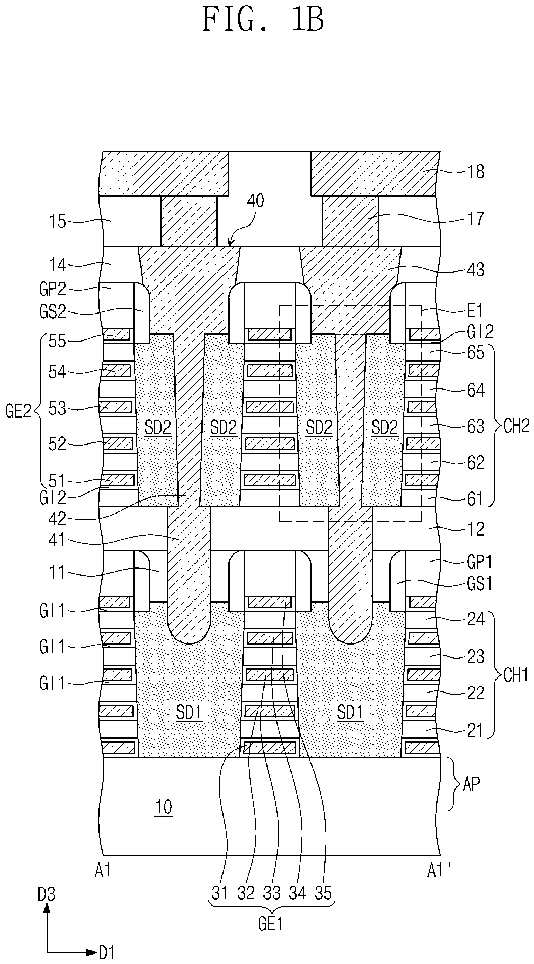

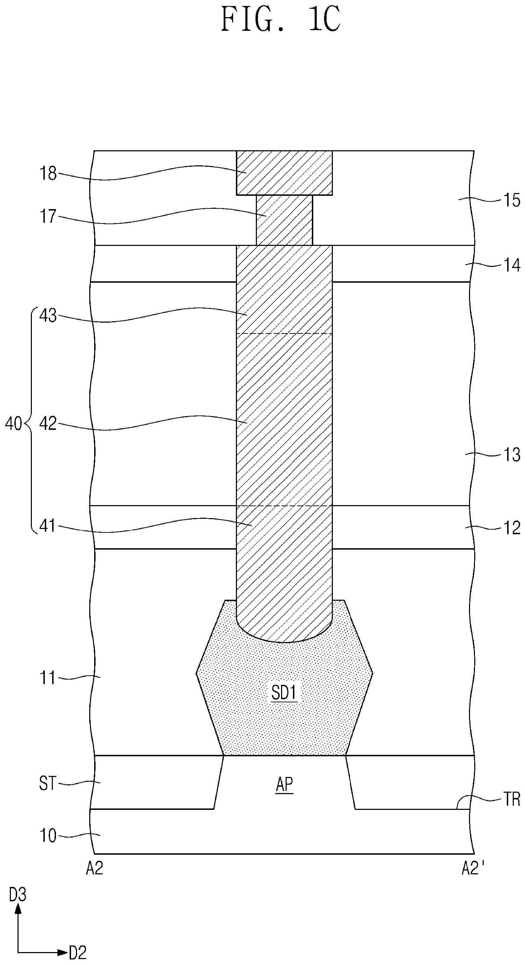

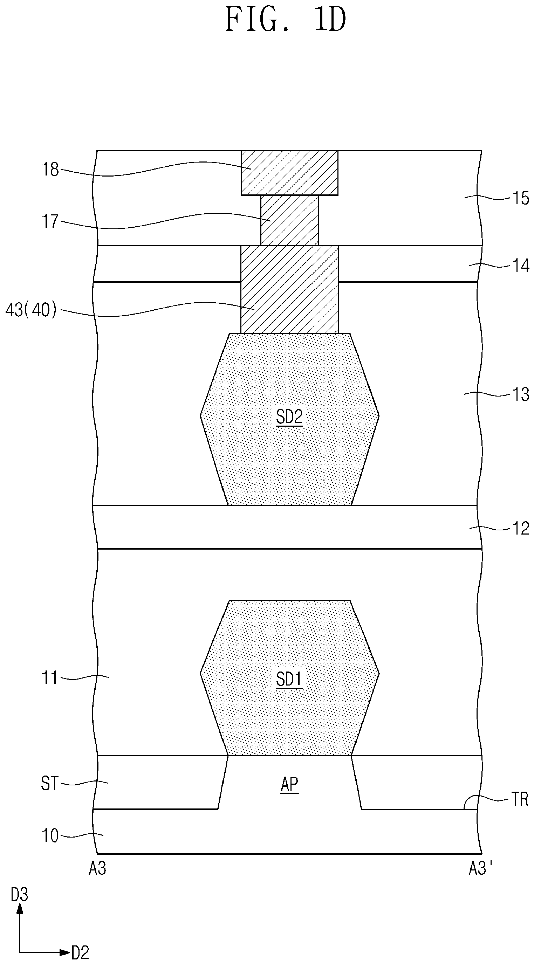

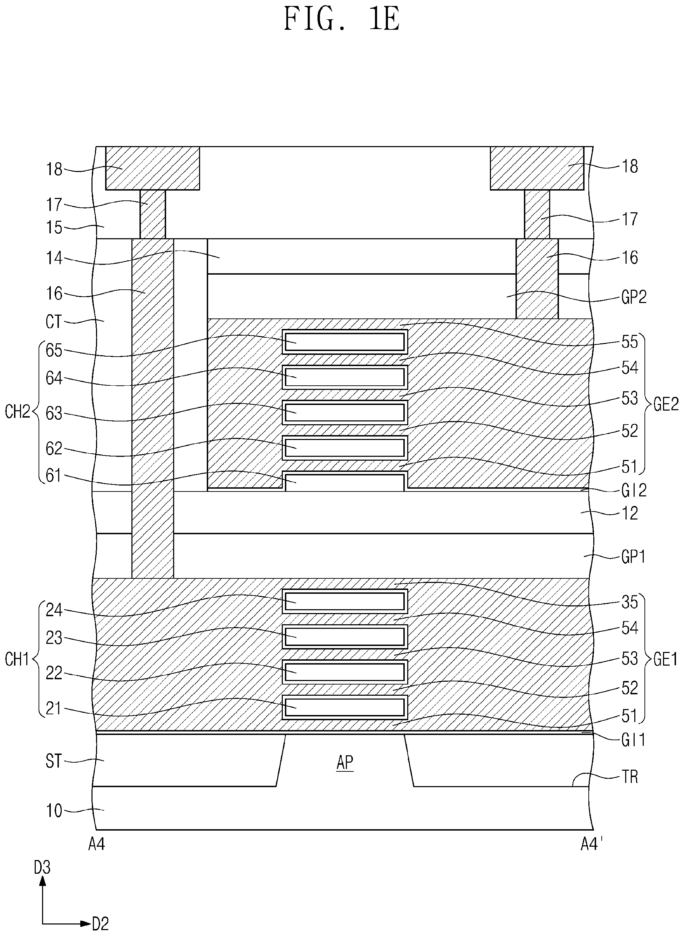

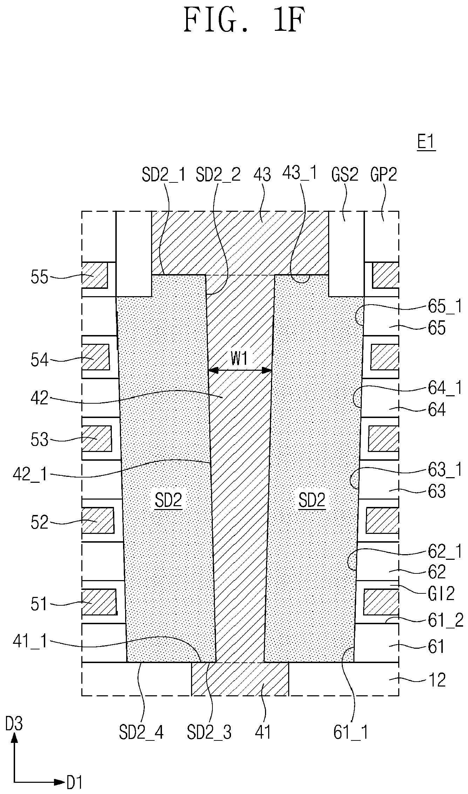

FIG. 1A is a plan view illustrating a semiconductor device according to some embodiments of the inventive concepts. FIG. 1B is a cross-sectional view taken along a line A1-A1' of FIG. 1A. FIG. 1C is a cross-sectional view taken along a line A2-A2' of FIG. 1A. FIG. 1D is a cross-sectional view taken along a line A3-A3' of FIG. 1A. FIG. 1E is a cross-sectional view taken along a line A4-A4' of FIG. 1A. FIG. 1F is an enlarged view illustrating a region `E1' of FIG. 1B.

Referring to FIGS. 1A, 1B, 1C, 1D and 1E, a semiconductor device may include a substrate 10. Logic transistors constituting a logic circuit may be disposed on the substrate 10. In some embodiments, the substrate 10 may be a semiconductor substrate. For example, the substrate 10 may include silicon, germanium, silicon-germanium, GaP, or GaAs. In some embodiments, the substrate 10 may be a silicon-on-insulator (SOI) substrate or a germanium-on-insulator (GOI) substrate. The substrate 10 may have a plate shape extending along a plane extending in a first direction D1 and a second direction D2. The first direction D1 and the second direction D2 may intersect each other. For example, the first direction D1 and the second direction D2 may be horizontal directions perpendicular to each other. A horizontal direction (e.g. the first direction D1 or the second direction D2) may be a direction perpendicular to an upper surface of the substrate 10.

The substrate 10 may include an active pattern AP. The active pattern AP may be defined by a trench TR on the substrate 10. The active pattern AP may extend in the first direction D1. The active pattern AP may be an upper portion of the substrate 10, which protrudes in a third direction D3. The third direction D3 may intersect the first direction D1 and the second direction D2. For example, the third direction D3 may be a vertical direction perpendicular to the first direction D1 and the second direction D2. A vertical direction (e.g. the third direction D3) may be a direction perpendicular to the upper service of the substrate 10.

A device isolation layer ST may be provided on the substrate 10. The device isolation layer ST may fill the trench TR. The device isolation layer ST may include an insulating material. For example, the device isolation layer ST may include an oxide.

First channel patterns CH1 may be provided on the active pattern AP. The first channel pattern CH1 may overlap with the active pattern AP in the third direction D3. As used herein, "an element A overlaps with an element B in a direction X" (or similar language) means that there is at least one line (e.g. one straight line) that extends in the direction X and intersects both the elements A and B. The first channel patterns CH1 overlapping with a single active pattern AP in the third direction D3 may be arranged in the first direction D1. The first channel patterns CH1 overlapping with the single active pattern AP in the third direction D3 may be spaced apart from each other in the first direction D1. For example, the first channel patterns CH1 may be arranged in the first direction D1 and may be spaced apart from each other in the first direction D1.

Each of the first channel patterns CH1 may include a first semiconductor pattern 21, a second semiconductor pattern 22, a third semiconductor pattern 23 and a fourth semiconductor pattern 24, which are sequentially arranged in the third direction D3. The first to fourth semiconductor patterns 21, 22, 23 and 24 of the first channel pattern CH1 may be spaced apart from each other in the third direction D3. The first to fourth semiconductor patterns 21, 22, 23 and 24 of the first channel pattern CH1 may overlap with each other in the third direction D3. Although 4 of the semiconductor patterns 21, 22, 23 and 24 are illustrated, in certain embodiments, the number of the semiconductor patterns 21, 22, 23 and 24 included in the first channel pattern CH1 may be 3 or less or may be 5 or more. That is, the first channel patterns CH1 may comprise any number of semiconductor patterns (e.g. one or more semiconductor patterns).

In some embodiments, the first to fourth semiconductor patterns 21, 22, 23 and 24 of the first channel pattern CH1 may include silicon (Si). For example, each of the first to fourth semiconductor patterns 21, 22, 23 and 24 of the first channel pattern CH1 may include crystalline silicon. In certain embodiments, the first to fourth semiconductor patterns 21, 22, 23 and 24 of the first channel pattern CH1 may include silicon-germanium (SiGe).

A plurality of first source/drain patterns SD1 may be provided on the active pattern AP. The first source/drain patterns SD1 may be disposed between the first channel patterns CH1. One of the first source/drain patterns SD1 may be disposed between two first channel patterns CH1 adjacent to each other in the first direction D1.

Each first source/drain pattern SD1 may be an epitaxial pattern formed by a selective epitaxial growth (SEG) process. The first source/drain patterns SD1 may include silicon (Si) or silicon-germanium (SiGe). The first source/drain patterns SD1 may be doped with dopants to have a first conductivity type. For example, the first conductivity type may be an N-type or a P-type.

First gate electrodes GE1 extending in the second direction D2 may be provided. Each first gate electrode GE1 may intersect a corresponding first channel pattern CH1. The first gate electrode GE1 may overlap with the first channel pattern CH1 in the third direction D3. The first gate electrodes GE1 may be arranged in the first direction D1. One of the first source/drain patterns SD1 may be disposed between two first gate electrodes GE1 adjacent to each other in the first direction D1.

Each first gate electrode GE1 may include a first portion 31 disposed between the active pattern AP and the first semiconductor pattern 21 of the first channel pattern CH1, a second portion 32 disposed between the first and second semiconductor patterns 21 and 22 of the first channel pattern CH1, a third portion 33 disposed between the second and third semiconductor patterns 22 and 23 of the first channel pattern CH1, a fourth portion 34 disposed between the third and fourth semiconductor patterns 23 and 24 of the first channel pattern CH1, and a fifth portion 35 on the fourth semiconductor pattern 24 of the first channel pattern CH1. The first gate electrode GE1 may include a conductive material. Whilst five portions are described herein, it will be appreciated that the number of portions may be adapted according to the number of semiconductor patterns. For instance, one portion may be provided between each adjacent pair of semiconductor patterns, one portion may be provided below the lowest semiconductor pattern, and one portion may be provided above the highest semiconductor pattern. In this regard, "lowest" and "highest" may refer to the positions along the third direction D3 (e.g. based on distance from the active pattern AP).

The first gate electrode GE1 and the first to fourth semiconductor patterns 21, 22, 23 and 24 of the first channel pattern CH1 surrounded by the first gate electrode GE1 may constitute a three-dimensional field effect transistor (e.g., a multi-bridge channel field effect transistor (MBCFET) or a gate-all-around field effect transistor (GAAFET)).

First gate insulating layers GI1 may be provided. The first gate insulating layer GI1 may separate the first gate electrode GE1 from the first channel pattern CH1. The first gate insulating layer GI1 may surround the first to fourth semiconductor patterns 21, 22, 23 and 24 of the first channel pattern CH1. As used herein, it will be understood that "an element A surrounds an element B" (or similar language) means that the element A is at least partially around the element B but does not necessarily mean that the element A completely encloses the element B. The first gate insulating layer GI1 may cover the device isolation layer ST. The first gate insulating layer GI1 may include an insulating material. For example, the first gate insulating layer GI1 may include an oxide.

First gate spacers GS1 may be disposed at both sides of the fifth portion 35 of the first gate electrode GE1. The first gate spacers GS1 may include an insulating material. A first gate capping pattern GP1 may be provided on the fifth portion 35 of the first gate electrode GE1. The first gate capping pattern GP1 may include an insulating material.

A first cover insulating layer 11 may be provided to cover the first source/drain patterns SD1. A first interlayer insulating layer 12 may be provided on the first cover insulating layer 11. The first cover insulating layer 11 and the first interlayer insulating layer 12 may include an insulating material. For example, the first cover insulating layer 11 and the first interlayer insulating layer 12 may include an oxide.

Second channel patterns CH2 may be provided on the first interlayer insulating layer 12. Each second channel pattern CH2 may overlap with a corresponding first channel pattern CH1 in the third direction D3. The first channel patterns CH1 may be disposed at a lower level than the second channel patterns CH2. For example, the second channel patterns CH2 may be on the first channel patterns CH1.

Each of the second channel patterns CH2 may include a first semiconductor pattern 61, a second semiconductor pattern 62, a third semiconductor pattern 63, a fourth semiconductor pattern 64 and a fifth semiconductor pattern 65, which are sequentially arranged in the third direction D3. The first to fifth semiconductor patterns 61, 62, 63, 64 and 65 of the second channel pattern CH2 may be spaced apart from each other in the third direction D3. The first to fifth semiconductor patterns 61, 62, 63, 64 and 65 of the second channel pattern CH2 may overlap with each other in the third direction D3. Although 5 of the semiconductor patterns 61, 62, 63, 64 and 65 are illustrated, in certain embodiments, the number of the semiconductor patterns 61, 62, 63, 64 and 65 included in the second channel pattern CH2 may be 4 or less or may be 6 or more. That is, the second channel patterns CH2 may comprise any number of semiconductor patterns (e.g. one or more semiconductor patterns).

In some embodiments, the first to fifth semiconductor patterns 61, 62, 63, 64 and 65 of the second channel pattern CH2 may include silicon (Si). For example, each of the first to fifth semiconductor patterns 61, 62, 63, 64 and 65 of the second channel pattern CH2 may include crystalline silicon. In certain embodiments, the first to fifth semiconductor patterns 61, 62, 63, 64 and 65 of the second channel pattern CH2 may include silicon-germanium (SiGe).

A plurality of second source/drain patterns SD2 may be provided on the first interlayer insulating layer 12. The second source/drain patterns SD2 may be disposed between the second channel patterns CH2. Two second source/drain patterns SD2 may be disposed between two second channel patterns CH2 adjacent to each other in the first direction D1. The two second source/drain patterns SD2 disposed between the two second channel patterns CH2 adjacent to each other in the first direction D1 may be spaced apart from each other in the first direction D1.

Each second source/drain pattern SD2 may be an epitaxial pattern formed by a selective epitaxial growth (SEG) process. The second source/drain patterns SD2 may include silicon (Si) or silicon-germanium (SiGe). The second source/drain patterns SD2 may be doped with dopants to have a second conductivity type different from the first conductivity type. For example, when the first conductivity type is an N-type, the second conductivity type may be a P-type.

Second gate electrodes GE2 extending in the second direction D2 may be provided. Each second gate electrode GE2 may intersect a corresponding second channel pattern CH2. The second gate electrode GE2 may overlap with the second channel pattern CH2 in the third direction D3. The second gate electrodes GE2 may be arranged in the first direction D1. Two second source/drain patterns SD2 may be disposed between two second gate electrodes GE2 adjacent to each other in the first direction D1.

Each second gate electrode GE2 may include a first portion 51 disposed between the first and second semiconductor patterns 61 and 62 of the second channel pattern CH2, a second portion 52 disposed between the second and third semiconductor patterns 62 and 63 of the second channel pattern CH2, a third portion 53 disposed between the third and fourth semiconductor patterns 63 and 64 of the second channel pattern CH2, a fourth portion 54 disposed between the fourth and fifth semiconductor patterns 64 and 65 of the second channel pattern CH2, and a fifth portion 55 on the fifth semiconductor pattern 65 of the second channel pattern CH2. The second gate electrode GE2 may include a conductive material. Whilst five portions are described herein, it will be appreciated that the number of portions may be adapted according to the number of semiconductor patterns. For instance, one portion may be provided between each adjacent pair of semiconductor patterns, one portion may be provided below the lowest semiconductor pattern, and one portion may be provided above the highest semiconductor pattern. In this regard, "lowest" and "highest" may refer to the positions along the third direction D3 (e.g. based on distance from the active pattern AP).

The second gate electrode GE2 and the first to fifth semiconductor patterns 61, 62, 63, 64 and 65 of the second channel pattern CH2 surrounded by the second gate electrode GE2 may constitute a three-dimensional field effect transistor (e.g., a MBCFET or a GAAFET).

Second gate insulating layers GI2 may be provided. The second gate insulating layer GI2 may separate the second gate electrode GE2 from the second channel pattern CH2. The second gate insulating layer GI2 may surround the first to fifth semiconductor patterns 61, 62, 63, 64 and 65 of the second channel pattern CH2. The second gate insulating layer GI2 may include an insulating material. For example, the second gate insulating layer GI2 may include an oxide.

Second gate spacers GS2 may be disposed at both sides of the fifth portion 55 of the second gate electrode GE2. The second gate spacers GS2 may include an insulating material. A second gate capping pattern GP2 may be provided on the fifth portion 55 of the second gate electrode GE2. The second gate capping pattern GP2 may include an insulating material.

A second cover insulating layer 13 may be provided to cover the second source/drain patterns SD2. A second interlayer insulating layer 14 may be provided on the second cover insulating layer 13. The second cover insulating layer 13 and the second interlayer insulating layer 14 may include an insulating material. For example, the second cover insulating layer 13 and the second interlayer insulating layer 14 may include an oxide.

An active contact 40 may be provided to penetrate or extend in the second interlayer insulating layer 14, the second cover insulating layer 13, the first interlayer insulating layer 12 and the first cover insulating layer 11. The active contact 40 may be in contact with the first and second source/drain patterns SD1 and SD2. For example, the active contact 40 may be in contact with one first source/drain pattern SD1 and two second source/drain patterns SD2. The active contact 40 may include a conductive material. An active contact 40 may be provided for each first source/drain pattern SD1.

The active contact 40 may include a first portion 41 disposed at a lower level than the second source/drain pattern SD2, a second portion 42 disposed at the same level as the second source/drain pattern SD2, and a third portion 43 disposed at a higher level than the second source/drain pattern SD2. As used herein, the term "level" means a height in the third direction D3 (e.g., a vertical direction) from a bottom surface of the substrate 10. The first portion 41 of the active contact 40 may be in contact with the first source/drain pattern SD1 and the second source/drain pattern SD2. The first portion 41 of the active contact 40 may penetrate or extend in the first interlayer insulating layer 12. The first interlayer insulating layer 12 may be disposed between the first and second channel patterns CH1 and CH2.

A width, in the first direction D1, of the first portion 41 of the active contact 40 may be greater than a width, in the first direction D1, of the second portion 42 of the active contact 40. The width, in the first direction D1, of the second portion 42 of the active contact 40 may be less than a width, in the first direction D1, of the third portion 43 of the active contact 40.

The active contact 40 may include the conductive material as described above. For example, the active contact 40 may include a metal. In some embodiments, the active contact 40 may include a metal silicide layer in contact with each of the first and second source/drain patterns SD1 and SD2, and a barrier layer in contact with the metal silicide layer.

A gate cutting pattern CT may be provided to penetrate or extend in the second interlayer insulating layer 14 and the second gate capping pattern GP2. The gate cutting pattern CT may cut the second gate electrode GE2. The gate cutting pattern CT may include an insulating material.

Gate contacts 16 may be provided. At least one of the gate contacts 16 may penetrate or extend in the gate cutting pattern CT, the first interlayer insulating layer 12 and the first gate capping pattern GP1 so as to be connected to the first gate electrode GE1. At least another of the gate contacts 16 may penetrate or extend in the second interlayer insulating layer 14 and the second gate capping pattern GP2 so as to be connected to the second gate electrode GE2. The gate contacts 16 may include a conductive material.

A third cover insulating layer 15 may be provided on the second interlayer insulating layer 14 and the active contacts 40. The third cover insulating layer 15 may include an insulating material.

Conductive contacts 17 and conductive lines 18 may be provided in the third cover insulating layer 15. At least one of the conductive contacts 17 may be connected to the active contact 40. At least another of the conductive contacts 17 may be connected to the gate contact 16. The conductive line 18 may extend in the first direction D1. The conductive line 18 may be connected to the conductive contact 17. The conductive contact 17 and the conductive line 18 may include a conductive material. In some embodiments, at least one of the conductive lines 18 may be a power line.

Referring to FIG. 1F, two second source/drain patterns SD2 may be in contact with one active contact 40. Side surfaces SD2_2 of the two second source/drain patterns SD2 may be in contact with the second portion 42 of the active contact 40. The side surface SD2_2 of the second source/drain pattern SD2 may be flat or substantially planar. The side surface SD2_2 of the second source/drain pattern SD2 may be inclined (e.g. angled relative to the third direction D3). For example, the side surface SD2_2 of the second source/drain pattern SD2 may be inclined with respect to a top surface of the substrate 10. A crystal plane of the side surface SD2_2 of the second source/drain pattern SD2 may be one of { 100} planes. That is, a crystal plane of the side surface SD2_2 may have a (100) Miller index. In this context, { 100} may represent the set of all planes with a Miller index of (100). { 100} may include all planes that are crystallographically equivalent to (100) by symmetry of the lattice. A crystal plane of a top surface 61_2 of the first semiconductor pattern 61 of the second channel pattern CH2 may be one of { 100} planes. A crystal plane of the top surface of the substrate 10 may be the same as or different from the crystal plane of the top surface 61_2 of the first semiconductor pattern 61.

The second portion 42 of the active contact 40 may include a side surface 42_1 in contact with the side surface SD2_2 of the second source/drain pattern SD2. The side surface 42_1 of the second portion 42 of the active contact 40 may be flat or substantially planar. The side surface 42_1 of the second portion 42 of the active contact 40 may be inclined. For example, the side surface 42_1 of the second portion 42 of the active contact 40 may be inclined with respect to the top surface of the substrate 10. Since the side surfaces SD2_2 of the two second source/drain patterns SD2 in contact with the second portion 42 of the active contact 40 are inclined, a width W1, in the first direction D1, of the second portion 42 of the active contact 40 may decrease as a level decreases. For example, a width W1, in the first direction D1, of the second portion 42 of the active contact 40 may decrease as a distance (e.g., in the third direction D3) to a top surface 41_1 of the first portion 41 of the active contact 40 decreases. The second portion 42 of the active contact 40 may be disposed between the second source/drain patterns SD2.

A bottom surface of the second source/drain pattern SD2 may include a first portion SD2_3 in contact with a top surface 41_1 of the first portion 41 of the active contact 40, and a second portion SD2_4 in contact with a top surface of the first interlayer insulating layer 12. A top surface SD2_1 of the second source/drain pattern SD2 may be in contact with a bottom surface 43_1 of the third portion 43 of the active contact 40.

The first to fifth semiconductor patterns 61, 62, 63, 64 and 65 of the second channel pattern CH2 may include side surfaces 61_1, 62_1, 63_1, 64_1 and 65_1 in contact with the second source/drain pattern SD2, respectively. Each of crystal planes of the side surfaces 61_1, 62_1, 63_1, 64_1 and 65_1 of the first to fifth semiconductor patterns 61, 62, 63, 64 and 65 of the second channel pattern CH2 may be one of { 100} planes. The side surfaces 61_1, 62_1, 63_1, 64_1 and 65_1 of the first to fifth semiconductor patterns 61, 62, 63, 64 and 65 of the second channel pattern CH2 may be flat or substantially planar. The side surfaces 61_1, 62_1, 63_1, 64_1 and 65_1 of the first to fifth semiconductor patterns 61, 62, 63, 64 and 65 of the second channel pattern CH2 may be inclined. For example, the side surfaces 61_1, 62_1, 63_1, 64_1 and 65_1 of the first to fifth semiconductor patterns 61, 62, 63, 64 and 65 of the second channel pattern CH2 may be inclined with respect to the top surface of the substrate 10.

In the semiconductor device according to the embodiments, each of the crystal planes of the side surfaces SD2_2 of the second source/drain patterns SD2 may be one of { 100} planes having relatively low surface energy, and thus the side surfaces SD2_2 of the second source/drain patterns SD2 may be flat or substantially planar. As a result, widths of the second portion 42 and the first portion 41 of the active contact 40 may be relatively uniform, and a contact area between the first portion 41 of the active contact 40 and the first source/drain pattern SD1 may be relatively uniform. For example, widths of the second portion 42 and the first portion 41 of the active contact 40 may have improved uniformity as a result of each of the crystal planes of the side surfaces SD2_2 of the second source/drain patterns SD2 being one of { 100} planes.

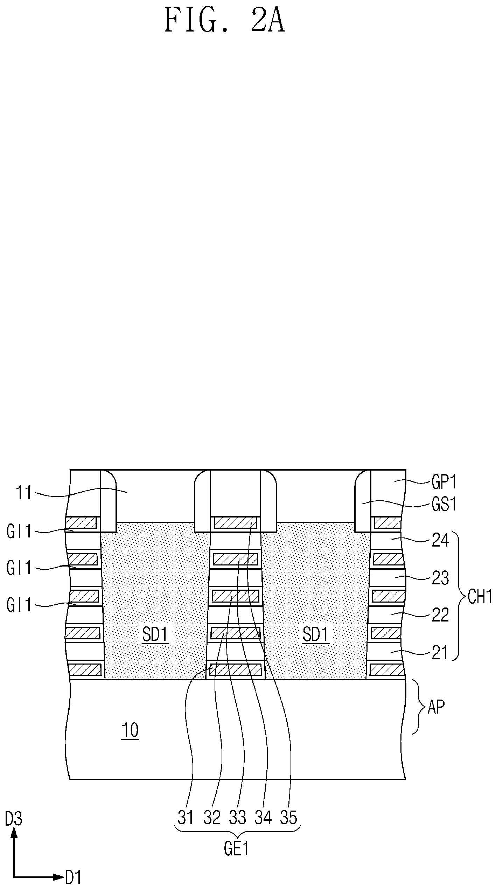

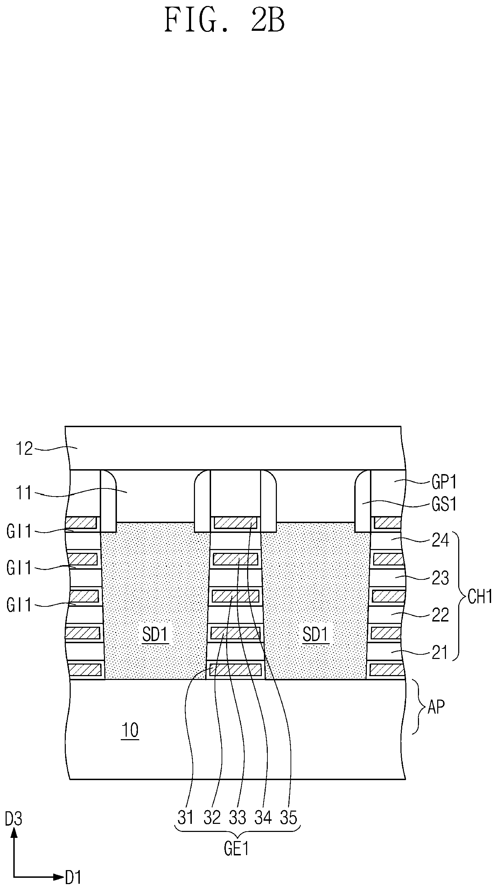

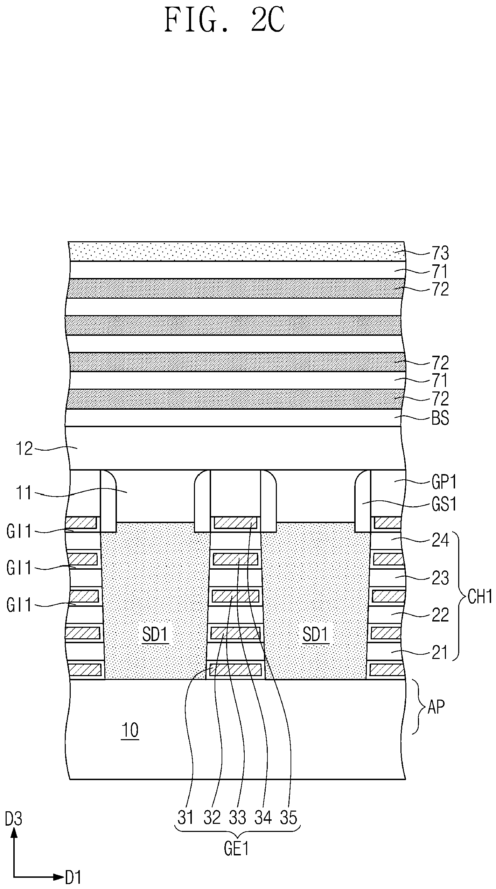

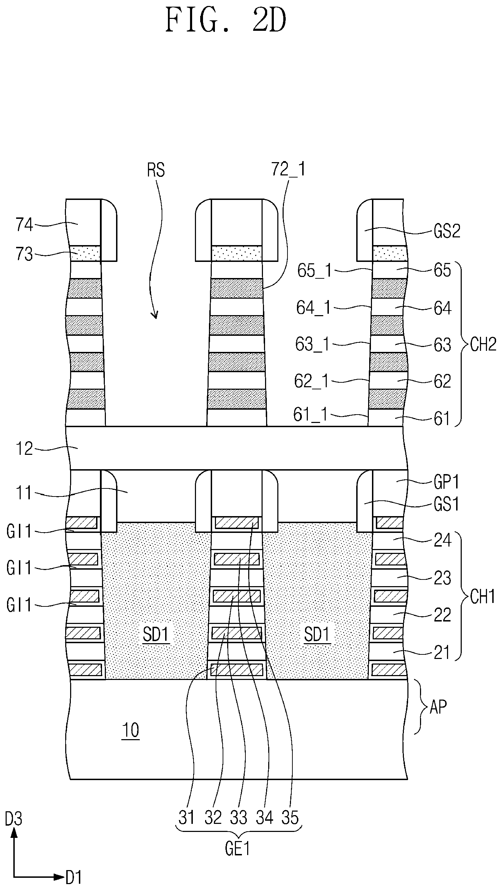

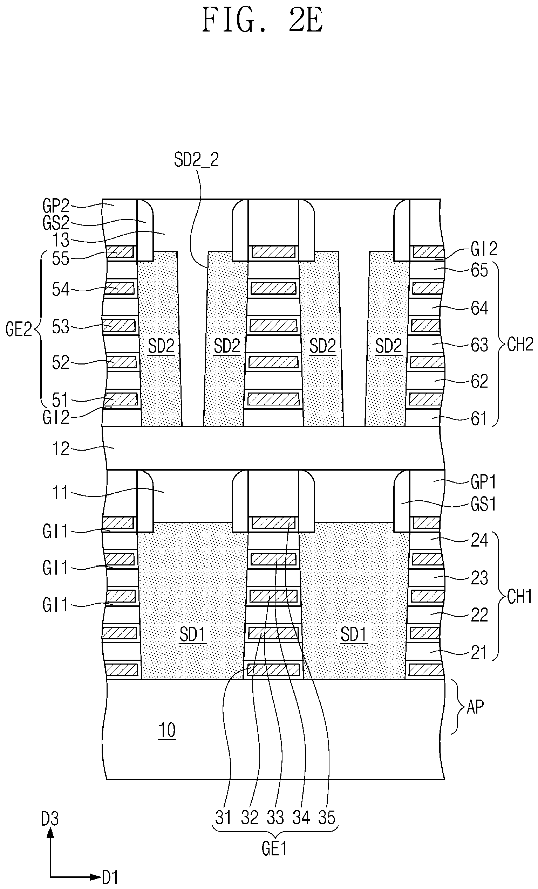

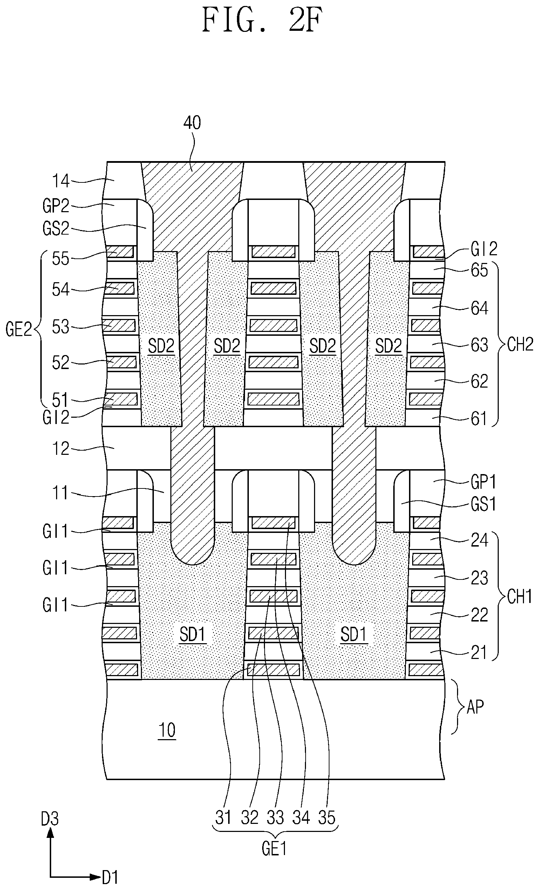

FIGS. 2A, 2B, 2C, 2D, 2E and 2F are cross-sectional views illustrating a method of manufacturing the semiconductor device according to FIGS. 1A to 1F.

Referring to FIG. 2A, an active pattern AP may be formed in a substrate 10. First channel patterns CH1, first source/drain patterns SD1, first gate insulating layers GI1, first gate electrodes GE1, first gate spacers GS1 and first gate capping patterns GP1 may be formed. The first source/drain pattern SD1 may be formed by performing a selective epitaxial process on the active pattern AP and the first to fourth semiconductor patterns 21, 22, 23 and 24 of the first channel pattern CH1. A first cover insulating layer 11 covering the first source/drain patterns SD1 may be formed.

Referring to FIG. 2B, a first interlayer insulating layer 12 may be formed on the first cover insulating layer 11.

Referring to FIG. 2C, a bonding substrate BS may be formed on the first interlayer insulating layer 12. First semiconductor layers 71 and second semiconductor layers 72 may be alternately formed on the bonding substrate BS. In some embodiments, the first and second semiconductor layers 71 and 72 may be formed after the bonding substrate BS is bonded onto the first interlayer insulating layer 12. In certain embodiments, the first and second semiconductor layers 71 and 72 may be formed on the bonding substrate BS, and then, the bonding substrate BS may be bonded to the first interlayer insulating layer 12.

A crystal plane of a top surface of the bonding substrate BS may be one of {100} planes. In some embodiments, the bonding substrate BS may be bonded in such a way that a crystal direction of a notch of the bonding substrate BS is one of <100> directions. That is, a crystal direction of the notch of the bonding substrate BS have a direction along the direct lattice vector [100]. In this context, <100> may represent the set of all directions along [100]. <100> may include all directions that are crystallographically equivalent to [100] by symmetry of the lattice.

The bonding substrate BS and the first semiconductor layers 71 may include a material capable of having an etch selectivity with respect to the second semiconductor layers 72. For example, the bonding substrate BS and the first semiconductor layers 71 may include silicon (Si), and the second semiconductor layers 72 may include silicon-germanium (SiGe).

A sacrificial layer 73 may be formed on an uppermost one of the first semiconductor layers 71. For example, the sacrificial layer 73 may be formed of poly-silicon.

Referring to FIG. 2D, mask patterns 74 may be formed on the sacrificial layer 73. The sacrificial layer 73 may be patterned using the mask patterns 74 as etch masks. A second gate spacer GS2 may be formed on a side surface of the patterned sacrificial layer 73 and a side surface of the mask pattern 74.

The bonding substrate BS, the first semiconductor layers 71 and the second semiconductor layers 72 may be patterned to form recesses RS. A top surface of the first interlayer insulating layer 12 may be exposed by the recess RS.

The bonding substrate BS may be patterned to form first semiconductor patterns 61 of second channel patterns CH2. The first semiconductor layers 71 may be patterned to form second to fifth semiconductor patterns 62, 63, 64 and 65 of the second channel patterns CH2. Side surfaces 61_1, 62_1, 63_1, 64_1 and 65_1 of the first to fifth semiconductor patterns 61, 62, 63, 64 and 65 of the second channel pattern CH2 may be exposed by the recess RS. Each of crystal planes of the side surfaces 61_1, 62_1, 63_1, 64_1 and 65_1 of the first to fifth semiconductor patterns 61, 62, 63, 64 and 65 of the second channel pattern CH2 may be one of { 100} planes. The second semiconductor layers 72 may be patterned to expose side surfaces 72_1 of the second semiconductor layers 72.

Referring to FIG. 2E, second source/drain patterns SD2 may be formed. The second source/drain patterns SD2 may be formed using a selective epitaxial growth process. Two second source/drain patterns SD2 may be formed to be spaced apart from each other in the first direction D1 between two second channel patterns CH2 adjacent to each other in the first direction D1. The top surface of the first interlayer insulating layer 12 may be exposed between the second source/drain patterns SD2. A crystal plane of a side surface SD2_2 of the second source/drain pattern SD2 may be one of { 100} planes.

A second cover insulating layer 13 covering the second source/drain patterns SD2 may be formed. The mask patterns 74, the patterned sacrificial layers 73 and the second semiconductor layers 72 may be removed. Second gate insulating layers GI2, second gate electrodes GE2 and second gate capping patterns GP2 may be formed in spaces formed by the removal of the mask patterns 74, the patterned sacrificial layers 73 and the second semiconductor layers 72.

Referring to FIG. 2F, a second interlayer insulating layer 14 may be formed on the second cover insulating layer 13 and the second gate capping patterns GP2. An active contact 40 may be formed. The formation of the active contact 40 may include etching the second interlayer insulating layer 14, the second cover insulating layer 13, the first interlayer insulating layer 12, the first cover insulating layer 11 and the first source/drain pattern SD1 to form a hole, and forming the active contact 40 filling the hole.

Referring to FIGS. 1A to 1E, a gate cutting pattern CT and gate contacts 16 may be formed. A third cover insulating layer 15 may be formed on the second interlayer insulating layer 14. Conductive contacts 17 and conductive lines 18 may be formed in the third cover insulating layer 15.

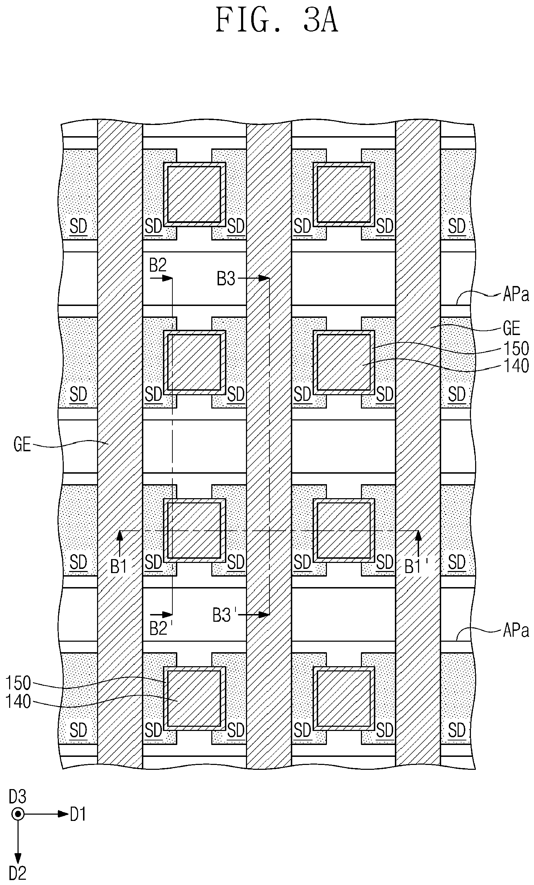

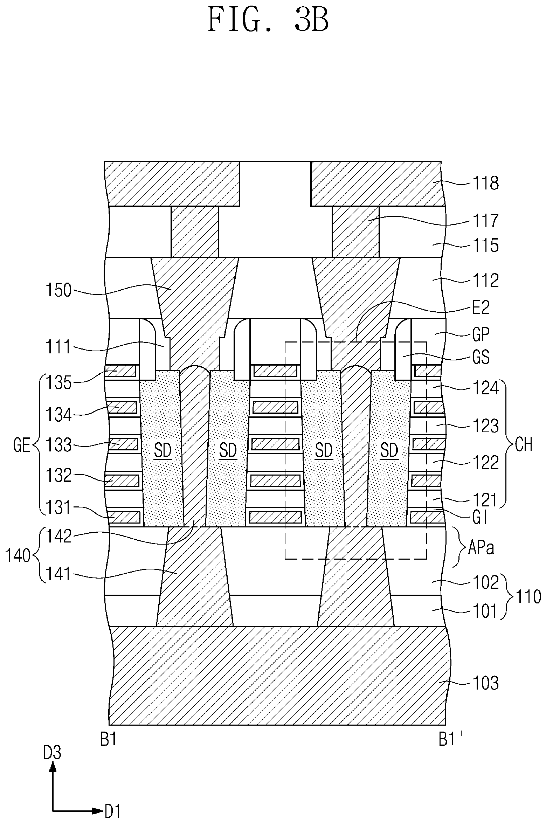

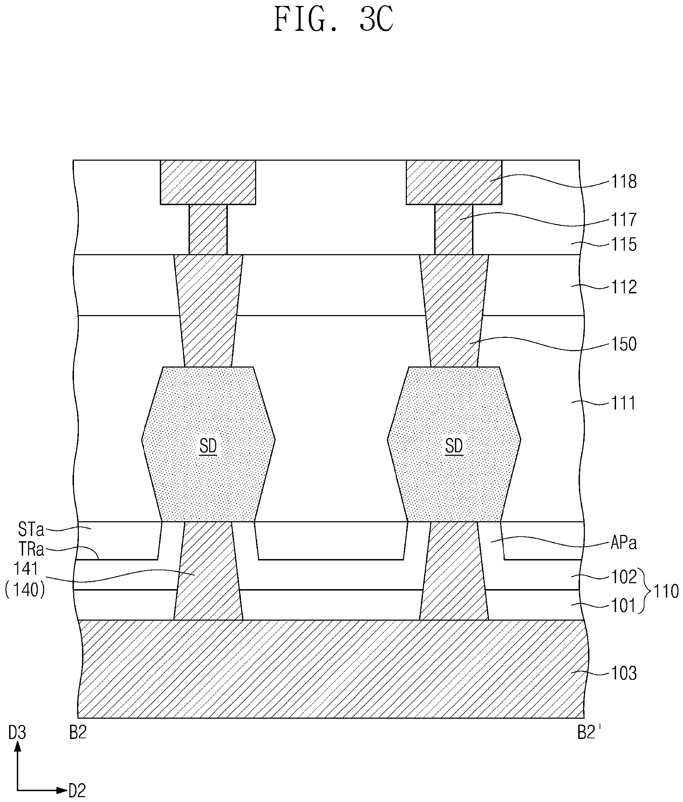

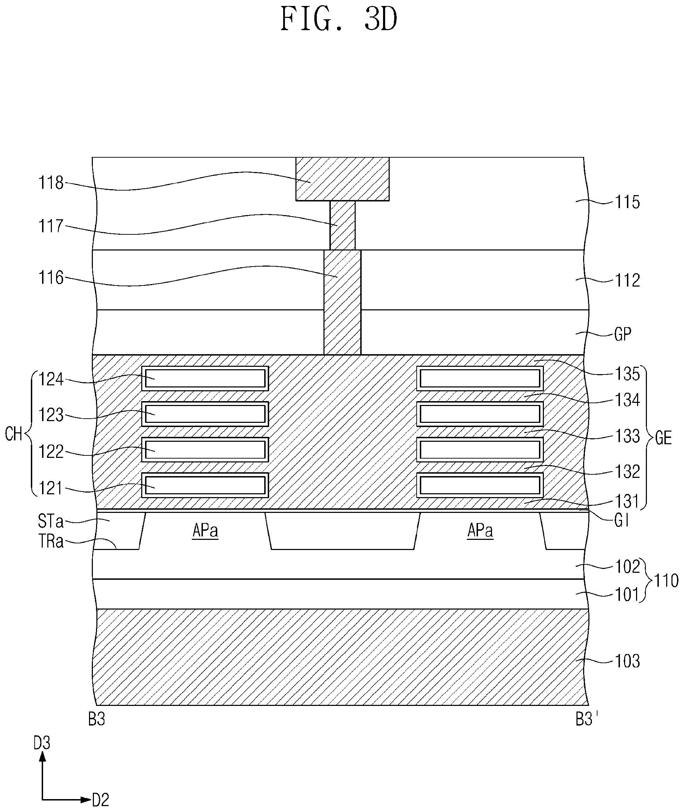

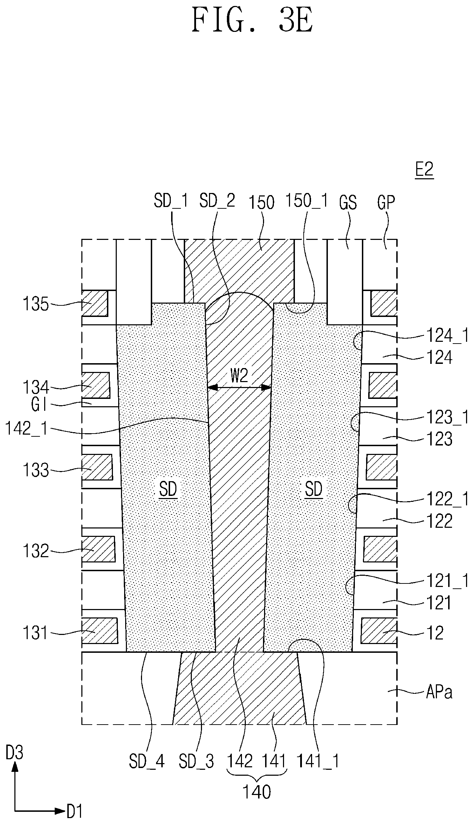

FIG. 3A is a plan view illustrating a semiconductor device according to some embodiments of the inventive concepts. FIG. 3B is a cross-sectional view taken along a line B1-B1' of FIG. 3A. FIG. 3C is a cross-sectional view taken along a line B2-B2' of FIG. 3A. FIG. 3D is a cross-sectional view taken along a line B3-B3' of FIG. 3A. FIG. 3E is an enlarged view illustrating a region 'E2' of FIG. 3B.

Referring to FIGS. 3A, 3B, 3C and 3D, a semiconductor device may include a substrate 110. Logic transistors constituting a logic circuit may be disposed on the substrate 110. The substrate 110 may include an insulating portion 101 and a semiconductor portion 102 on the insulating portion 101. The insulating portion 101 may include an insulating material, and the semiconductor portion 102 may include a semiconductor material. In certain embodiments, the substrate 110 may be a semiconductor substrate.

The semiconductor portion 102 of the substrate 110 may include active patterns APa. The active patterns APa may be defined by trenches TRa in the substrate 110. The active patterns APa may extend in a first direction D1. The active patterns APa may be arranged in a second direction D2. A device isolation layer STa may be provided on the substrate 110. The device isolation layer STa may fill the trench TRa.

Channel patterns CH may be provided on the active pattern APa. Each channel pattern CH may include a first semiconductor pattern 121, a second semiconductor pattern 122, a third semiconductor pattern 123 and a fourth semiconductor pattern 124, which are sequentially arranged in a third direction D3. Although 4 of the semiconductor patterns 121, 122, 123 and 124 are illustrated, in certain embodiments, the number of the semiconductor patterns 121, 122, 123 and 124 included in the channel patterns CH may be 3 or less or may be 5 or more. That is, the channel patterns CH may comprise any number of semiconductor patterns (e.g. one or more semiconductor patterns).

A plurality of source/drain patterns SD may be provided on the active pattern APa. The source/drain patterns SD may be disposed between the channel patterns CH. Two source/drain patterns SD may be disposed between two channel patterns CH adjacent to each other in the first direction D1. The two source/drain patterns SD disposed between the two channel patterns CH adjacent to each other in the first direction D1 may be spaced apart from each other in the first direction D1.

The source/drain patterns SD may be doped with dopants to have a first conductivity type or a second conductivity type different from the first conductivity type. In some embodiments, four source/drain patterns SD sequentially arranged in the second direction D2 may have the first conductivity type, the second conductivity type, the second conductivity type, and the first conductivity type, respectively.

Gate electrodes GE extending in the second direction D2 may be provided. The gate electrodes GE may be arranged in the first direction D1. Two source/drain patterns SD may be disposed between two gate electrodes GE adjacent to each other in the first direction D1.

The gate electrode GE may include a first portion 131 disposed between the active pattern APa and the first semiconductor pattern 121 of the channel pattern CH, a second portion 132 disposed between the first and second semiconductor patterns 121 and 122 of the channel pattern CH, a third portion 133 disposed between the second and third semiconductor patterns 122 and 123 of the channel pattern CH, a fourth portion 134 disposed between the third and fourth semiconductor patterns 123 and 124 of the channel pattern CH, and a fifth portion 135 on the fourth semiconductor pattern 124 of the channel pattern CH. Whilst five portions are described herein, it will be appreciated that the number of portions may be adapted according to the number of semiconductor patterns. For instance, one portion may be provided between each adjacent pair of semiconductor patterns, one portion may be provided below the lowest semiconductor pattern, and one portion may be provided above the highest semiconductor pattern. In this regard, "lowest" and "highest" may refer to the positions along the third direction D3 (e.g. based on distance from the active pattern APa).

The gate electrode GE and the first to fourth semiconductor patterns 121, 122, 123 and 124 of the channel pattern CH surrounded by the gate electrode GE may constitute a three-dimensional field effect transistor (e.g., a MBCFET or a GAAFET).

Gate insulating layers GI may be provided. The gate insulating layer GI may separate the gate electrode GE from the channel pattern CH.

Gate spacers GS may be disposed at both sides of the fifth portion 135 of the gate electrode GE. A gate capping pattern GP may be provided on the fifth portion 135 of the gate electrode GE. A first cover insulating layer 111 covering the source/drain patterns SD may be provided. An interlayer insulating layer 112 may be provided on the first cover insulating layer 111.

First active contacts 140 may be provided to penetrate or extend in the insulating portion 101 and the semiconductor portion 102 of the substrate 110. The first active contact 140 may be in contact with the source/drain pattern SD. For example, the first active contact 140 may be in contact with two source/drain patterns SD. One first active contact 140 may be provided for each pair of source/drain patterns SD.

The first active contact 140 may include a first portion 141 disposed at a lower level than the source/drain pattern SD, and a second portion 142 disposed at the same level as the source/drain pattern SD. The first portion 141 and the second portion 142 of the first active contact 140 may be in contact with the source/drain pattern SD. A width, in the first direction D 1, of the first portion 141 of the first active contact 140 may be greater than a width, in the first direction D1, of the second portion 142 of the first active contact 140. The width, in the first direction D1, of the first portion 141 of the first active contact 140 may increase as a level decreases. For example, the width, in the first direction D1, of the first portion 141 of the first active contact 140 may decrease as a distance (e.g., in the third direction D3) to a bottom surface of the second portion 142 of the first active contact 140 decreases. The first portion 141 of the first active contact 140 may penetrate or extend in the active pattern APa of the semiconductor portion 102.

The first active contact 140 may include a conductive material. For example, the first active contact 140 may include a metal. In some embodiments, the first active contact 140 may include a metal silicide layer in contact with the source/drain pattern SD, and a barrier layer in contact with the metal silicide layer.

Second active contacts 150 may be provided to penetrate or extend in the interlayer insulating layer 112 and the first cover insulating layer 111. One second active contact 150 may be provided for each first active contact 140. The second active contact 150 may be in contact with the source/drain pattern SD. For example, the second active contact 150 may be in contact with two source/drain patterns SD.

The second active contact 150 may be disposed at a higher level than the source/drain pattern SD. The second active contact 150 may be disposed at a higher level than the first active contact 140. A width of the second active contact 150 in the first direction D1 may be greater than the width, in the first direction D1, of the second portion 142 of the first active contact 140. The width of the second active contact 150 in the first direction D1 may decrease as a level decreases. For example, the width of the second active contact 150 in the first direction D1 may decrease as a distance (e.g., in the third direction D3) to a top surface of the second portion 142 of the first active contact 140 decreases.

The second active contact 150 may include a conductive material. For example, the second active contact 150 may include a metal. In some embodiments, the second active contact 150 may include a metal silicide layer in contact with the source/drain pattern SD, and a barrier layer in contact with the metal silicide layer.

A gate contact 116 may be provided. The gate contact 116 may penetrate or extend in the interlayer insulating layer 112 and the gate capping pattern GP so as to be connected to the gate electrode GE. A second cover insulating layer 115 may be provided on the interlayer insulating layer 112 and the second active contacts 150. Conductive contacts 117 and conductive lines 118 may be provided in the second cover insulating layer 115.

A power delivery conductive layer 103 may be disposed in contact with the first active contact 140. The power delivery conductive layer 103 may be in contact with a bottom surface of the first portion 141 of the first active contact 140. The substrate 110 may be provided on the power delivery conductive layer 103. The power delivery conductive layer 103 may include a conductive material.

Referring to FIG. 3E, side surfaces SD_2 of two source/drain patterns SD may be in contact with the second portion 142 of the first active contact 140. The side surface SD_2 of the source/drain pattern SD may be flat or substantially planar. The side surface SD_2 of the source/drain pattern SD may be inclined. For example, the side surface SD_2 of the source/drain pattern SD may be inclined with respect to a top surface of the substrate 110. A crystal plane of the side surface SD_2 of the source/drain pattern SD may be one of {100} planes.

The second portion 142 of the first active contact 140 may include a side surface 142_1 in contact with the side surface SD_2 of the source/drain pattern SD. The side surface 142_1 of the second portion 142 of the first active contact 140 may be flat or substantially planar. The side surface 142_1 of the second portion 142 of the first active contact 140 may be inclined. For example, the side surface 142_1 of the second portion 142 of the first active contact 140 may be inclined with respect to the top surface of the substrate 110. Since the side surfaces SD_2 of the two source/drain patterns SD in contact with the second portion 142 of the first active contact 140 are inclined, a width W2, in the first direction D1, of the second portion 142 of the first active contact 140 may decrease as a level decreases. For example, a width W2, in the first direction D1, of the second portion 142 of the first active contact 140 may decrease as a distance (e.g., in the third direction D3) to a top surface 141_1 of the first portion 141 of the first active contact 140 decreases. The second portion 142 of the first active contact 140 may be disposed between the source/drain patterns SD.

A bottom surface of the source/drain pattern SD may include a first portion SD_3 in contact with a top surface 141_1 of the first portion 141 of the first active contact 140, and a second portion SD_4 in contact with a top surface of the active pattern APa. A top surface SD_1 of the source/drain pattern SD may be in contact with a bottom surface 150_1 of the second active contact 150.

The first to fourth semiconductor patterns 121, 122, 123 and 124 of the channel pattern CH may include side surfaces 121_1, 122_1, 123_1 and 124_1 in contact with the source/drain pattern SD. Each of crystal planes of the side surfaces 121_1, 122_1, 123_1 and 124_1 of the first to fourth semiconductor patterns 121, 122, 123 and 124 of the channel pattern CH may be one of {100} planes. The side surfaces 121_1, 122_1, 123_1 and 124_1 of the first to fourth semiconductor patterns 121, 122, 123 and 124 of the channel pattern CH may be flat or substantially planar. The side surfaces 121_1, 122_1, 123_1 and 124_1 of the first to fourth semiconductor patterns 121, 122, 123 and 124 of the channel pattern CH may be inclined. For example, the side surfaces 121_1, 122_1, 123_1 and 124_1 of the first to fourth semiconductor patterns 121, 122, 123 and 124 of the channel pattern CH may be inclined with respect to the top surface of the substrate 110.

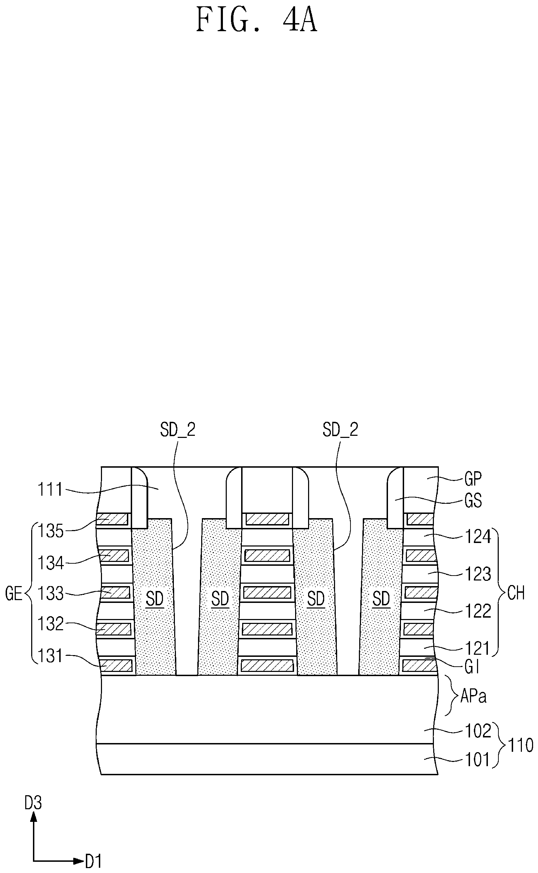

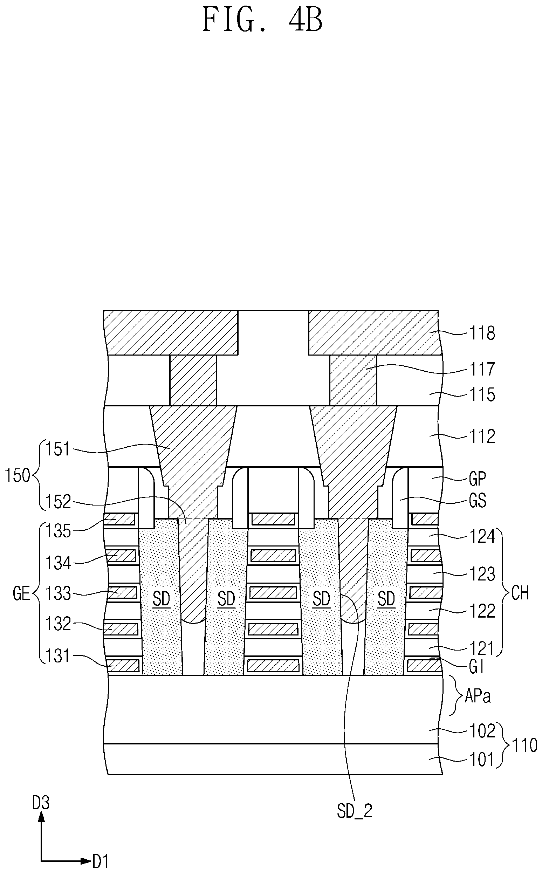

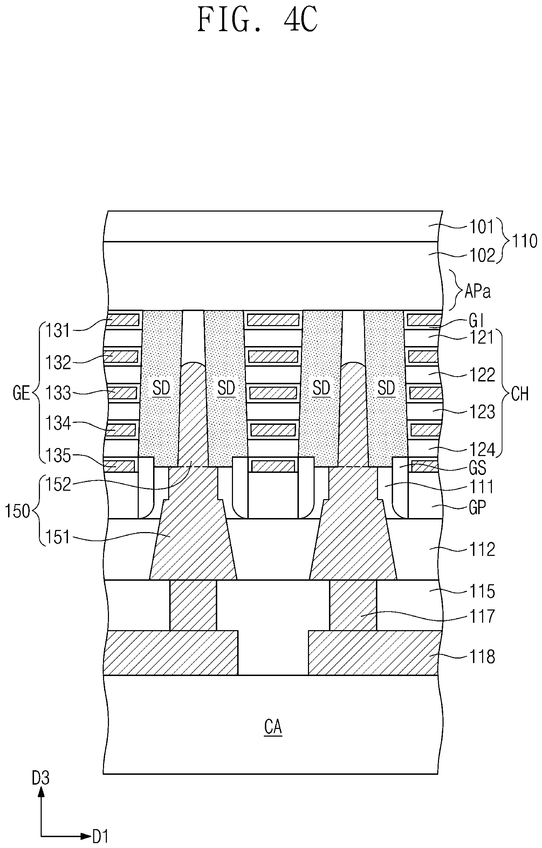

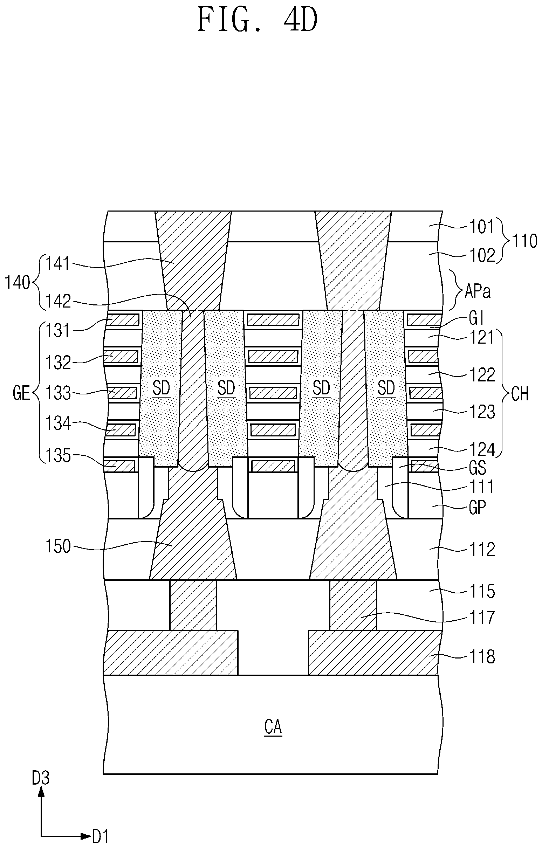

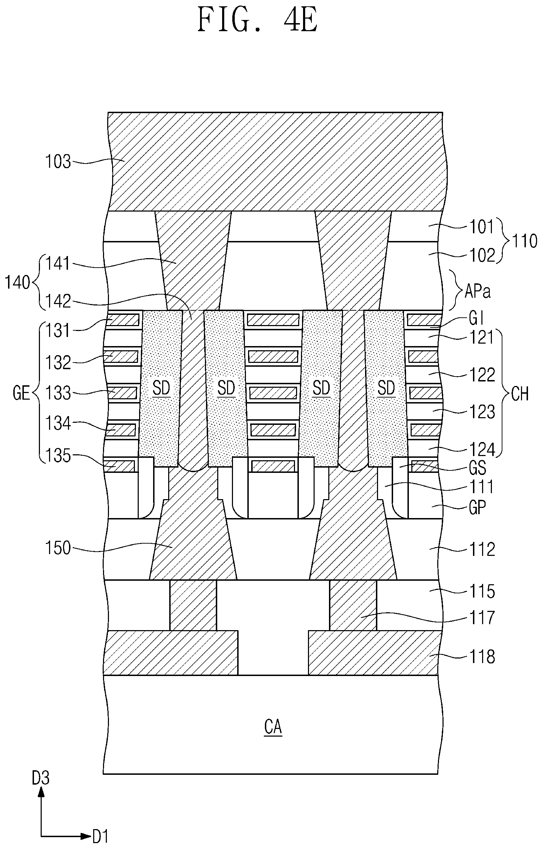

FIGS. 4A, 4B, 4C, 4D and 4E are cross-sectional views illustrating a method of manufacturing the semiconductor device according to FIGS. 3A to 3E.

Referring to FIG. 4A, an active pattern APa may be formed in a substrate 110. Channel patterns CH, source/drain patterns SD and a first cover insulating layer 111 may be formed. Gate insulating layers GI, gate electrodes GE, gate spacers GS and gate capping patterns GP may be formed.

Referring to FIG. 4B, an interlayer insulating layer 112 may be formed on the first cover insulating layer 111. Second active contacts 150 may be formed to penetrate or extend in the interlayer insulating layer 112. The second active contact 150 may include a first portion 151 in contact with a top surface of the source/drain pattern SD, and a second portion 152 in contact with a side surface SD_2 of the source/drain pattern SD. A width, in the first direction D1, of the second portion 152 of the second active contact 150 may decrease as a level decreases. For example, a width, in the first direction D1, of the second portion 152 of the second active contact 150 may decrease as a distance (e.g., in the third direction D3) to a top surface of the substrate 110 decreases.

The formation of the second active contact 150 may include etching the interlayer insulating layer 112 and the first cover insulating layer 111 to form a first hole, and forming the second active contact 150 filling the first hole.

A second cover insulating layer 115 may be formed on the interlayer insulating layer 112. Conductive contacts 117 and conductive lines 118 may be formed in the second cover insulating layer 115.

Referring to FIG. 4C, the substrate 110 may be turned over, and the second cover insulating layer 115 may be bonded onto a carrier substrate CA.

Referring to FIG. 4D, first active contacts 140 may be formed to penetrate or extend in the substrate 110. The formation of the first active contact 140 may include etching the substrate 110, the first cover insulating layer 111 and the second portion 152 of the second active contact 150 to form a second hole, and forming the first active contact 140 filling the second hole.

Referring to FIG. 4E, a power delivery conductive layer 103 may be formed on the substrate 110 and the first active contacts 140.

Referring to FIGS. 3A to 3D, the carrier substrate CA may be removed.

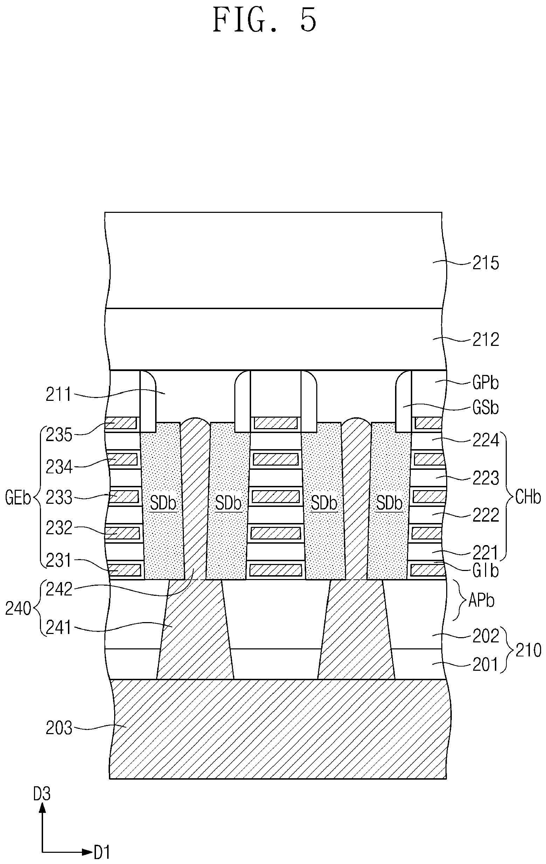

FIG. 5 is a cross-sectional view illustrating a semiconductor device according to some embodiments of the inventive concepts.

Referring to FIG. 5, a semiconductor device may include a power delivery conductive layer 203, a substrate 210 including an insulating portion 201 and a semiconductor portion 202, a channel pattern CHb including first to fourth semiconductor patterns 221, 222, 223 and 224, source/drain patterns SDb, a gate electrode GEb including first to fifth portions 231, 232, 233, 234 and 235, gate spacers GSb, a gate capping pattern GPb, a first cover insulating layer 211, an interlayer insulating layer 212, and a second cover insulating layer 215. The semiconductor portion 202 of the substrate 210 may include an active pattern APb.

An active contact 240 may be disposed in contact with the source/drain patterns SDb. The active contact 240 may include a first portion 241 in contact with the power delivery conductive layer 203, and a second portion 242 disposed between the source/drain patterns SDb. A top surface of the second portion 242 of the active contact 240 may be in contact with the first cover insulating layer 211. A top surface of the source/drain pattern SDb may be in contact with the first cover insulating layer 211. The top surface of the source/drain pattern SDb may be spaced apart from the active contact 240.

For example, the {100} and {110} planes may be crystal planes in a crystal lattice of a wafer (e.g., a silicon wafer). The {110} planes may have relatively high surface energy, and thus the growth surface of a source/drain pattern may be roughly grown, which may result in an active contact having a width with reduced uniformity. The { 100} planes may have relatively low surface energy, and thus the growth surface of a source/drain pattern may be flat or substantially planar. In the semiconductor device according to the embodiments of the inventive concepts, since the crystal plane of the side surface of the source/drain pattern is one of { 100} planes, the side surface of the source/drain pattern may be flat or substantially planar and the width of the active contact may be relatively uniform.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

While example embodiments of the inventive concepts have been particularly shown and described, it will be understood by one of ordinary skill in the art that variations in form and detail may be made therein without departing from the scope of the attached claims.

## Claims

1. A semiconductor device comprising:
first channel patterns adjacent to each other;
a first gate electrode that overlaps with one of the first channel patterns;
first source/drain patterns between the first channel patterns; and
a first active contact in contact with a side surface of each of the first source/drain patterns,
wherein a crystal plane of the side surface of each of the first source/drain patterns is one of { 100} planes.

2. The semiconductor device of claim 1, wherein the side surface of each of the first source/drain patterns is substantially planar.

3. The semiconductor device of claim 1 or claim 2, wherein the first active contact comprises:
a first portion in contact with respective bottom surfaces of the first source/drain patterns; and
a second portion in contact with the side surface of each of the first source/drain patterns.

4. The semiconductor device of claim 3, wherein a width of the first portion of the first active contact is greater than a width of the second portion of the first active contact.

5. The semiconductor device of claim 3 or claim 4, wherein a width of the second portion of the first active contact decreases as a distance to a top surface of the first portion of the first active contact decreases.

6. The semiconductor device of any of claims 3-5, wherein the first active contact further comprises a third portion in contact with respective top surfaces of the first source/drain patterns.

7. The semiconductor device of any of claims 3-6, further comprising a power delivery conductive layer in contact with a bottom surface of the first portion of the first active contact.

8. The semiconductor device of any preceding claim, wherein the side surface of each of the first source/drain patterns is inclined.

9. The semiconductor device of any preceding claim, further comprising:
second channel patterns adjacent to each other;
a second gate electrode that overlaps with one of the second channel patterns; and
a second source/drain pattern between the second channel patterns,
wherein the first channel patterns are on the second channel patterns, and
wherein the first active contact is in contact with the second source/drain pattern.

10. The semiconductor device of any preceding claim, wherein the side surface of each of the first source/drain patterns is substantially planar.

11. The semiconductor device of any preceding claim, wherein the first active contact comprises a first portion in contact with respective bottom surfaces of the first source/drain patterns and a second portion in contact with the side surface of each of the first source/drain patterns.

12. The semiconductor device of claim 11, wherein a width of the second portion of the first active contact decreases as a distance to a top surface of the first portion of the first active contact decreases.

13. The semiconductor device of claim 11 or claim 12, further comprising a power delivery conductive layer in contact with a bottom surface of the first portion of the first active contact.

14. The semiconductor device of any preceding claim, further comprising a second active contact in contact with respective top surfaces of the first source/drain patterns.

15. The semiconductor device of claim 14 wherein a width of the second active contact decreases as a distance to a top surface of the second portion of the first active contact decreases.
